# EUROPÄISCHE PATENTANMELDUNG

(11) **EP 1 889 942 A1**
(43) Veröffentlichungstag der Anmeldung: **20.02.2008**
(21) Anmeldenummer: 06119007.0
(22) Anmeldetag: 16.08.2006
(51) Int. Cl.: C23C 14/24

(54) **Verdampfervorrichtung mit automatischer Materialzuführung**

(71) Anmelder: Applied Materials GmbH & Co. KG, 63755 Alzenau (DE)
(72) Erfinder: Englert, Ulrich, 63869 Heigenbrücken (DE); Hattendorf, Guido, 63636 Brachttal (DE); Schäfer, Michael, 63674 Altenstadt (DE)
(74) Vertreter: Schickedanz, Willi

(57) **Zusammenfassung**

Die Erfindung betrifft eine Verdampfervorrichtung mit automatischer Zuführung eines Drahts in einen Tiegel. Alle Einzelteile dieser Verdampfervorrichtung sind auf nur einer Trägerplatte montiert, sodass eine schnelle Montage oder Demontage z. B. in Reinräumen möglich ist, ohne dass Partikel erzeugt werden. Außerdem ist eine Heizspirale von einem Schutzrohr umgeben, sodass diese Heizspirale nicht mit dem zu verdampfenden Material in Berührung kommt.

## Beschreibung

Die Erfindung betrifft eine Verdampfervorrichtung nach dem Oberbegriff des Patentanspruchs 1.

Moderne Flachbildschirme weisen für die Wiedergabe von Bildern oder Schriftzeichen Flüssigkristallelemente oder Plasmaelemente auf. Neuerdings werden auch Flachbildschirme hergestellt, die organische Leuchtdioden (OLEDs) als Farbpixel aufweisen.

Bei der Herstellung eines OLED-Flachbildschirms wird auf eine Glasplatte zunächst eine ITO (= Indium-Zinn-Oxid)-Schicht aufgebracht, die für Licht durchsichtig, aber elektrisch leitend ist. Auf diese Schicht wird dann das OLED-Material aufgedampft, auf das nun als nächste Schicht ein Metall aufgedampft werden kann.

Um Dampf zu erzeugen, sind Verdampfer vorgesehen, die das zu verdampfende Material aufheizen.

Die Heizaggregate zum Verdampfen von Metallen sind in der Regel um ein Verdampferrohr herum gelagert (DE 38 17 513 C2, DE 101 28 091 C1). Nachteilig ist bei außerhalb des Verdampferrohrs liegenden Heizaggregaten, dass sie große thermische Verluste aufweisen. Bei der Beschichtung von OLEDs mit Metallen, wo zum Verdampfen der Metalle Temperaturen von über 1200 °C erzeugt werden müssen, beeinträchtigen solche Heizaggregate aufgrund ihrer Wärmeabstrahlung die OLEDs negativ.

Es ist indessen auch schon eine Verdampfungsvorrichtung bekannt, die auf der Innenwand ihres Verdampfers eine Widerstandsheizung in Form einer Graphitschicht aufweist (US-A-5 157 240). Dem bei der Verdampfungsvorrichtung verwendeten Tiegel kann hierbei das zu verdampfende Material jedoch nicht kontinuierlich zugeführt werden.

Verdampfer, denen das zu verdampfende Material automatisch und in Drahtform zugeführt werden kann, sind ebenfalls bekannt (US 3 467 058, GB 1 203 069). Bei diesen Verdampfern muss das zu beschichtende Material parallel zu der Oberfläche des zu verdampfenden Materials angeordnet sein.

Der Erfindung liegt die Aufgabe zugrunde, einen kompakten Verdampfer, vorzugsweise für Metalle, mit einer kontinuierlichen Materialzuführung für die Beschichtung auch vertikal geführter Substrate zu schaffen.

Diese Aufgabe wird mit den Merkmalen des Patentanspruchs 1 gelöst.

Die Erfindung betrifft somit eine Verdampfervorrichtung mit automatischer Zuführung eines Drahts in einen Tiegel. Alle Einzelteile dieser Verdampfervorrichtung sind auf nur einer Trägerplatte montiert, sodass eine schnelle Montage oder Demontage z. B. in Reinräumen möglich ist, ohne dass Partikel erzeugt werden. Außerdem ist eine Heizspirale von einem Schutzrohr umgeben, sodass diese Heizspirale nicht mit dem zu verdampfenden Material in Berührung kommt.

Der mit der Erfindung erzielte Vorteil besteht insbesondere darin, dass die Oberfläche der Heizelemente nicht in Kontakt mit gegebenenfalls aggressivem Metalldampf kommt. Die komplette Verdampfereinheit kann an einem Flansch angebracht und leicht an einer Beschichtungsanlage montiert bzw. von dieser demontiert werden. Da die Verdampfereinheit thermisch gekapselt ist, strahlt sie kaum Wärme an die Umgebung ab.

Ein Ausführungsbeispiel der Erfindung ist in den Zeichnungen dargestellt und wird im Folgenden näher beschrieben.

Es zeigen:
Fig. 1 eine perspektivische Ansicht eines linearen Verdampfers;
Fig. 2 eine Seitenansicht des Verdampfers gemäß Fig. 1, wobei ein Teil der Seite aufgebrochen ist;
Fig. 3 eine Explosionsdarstellung des Verdampfers gemäß Fig. 1.

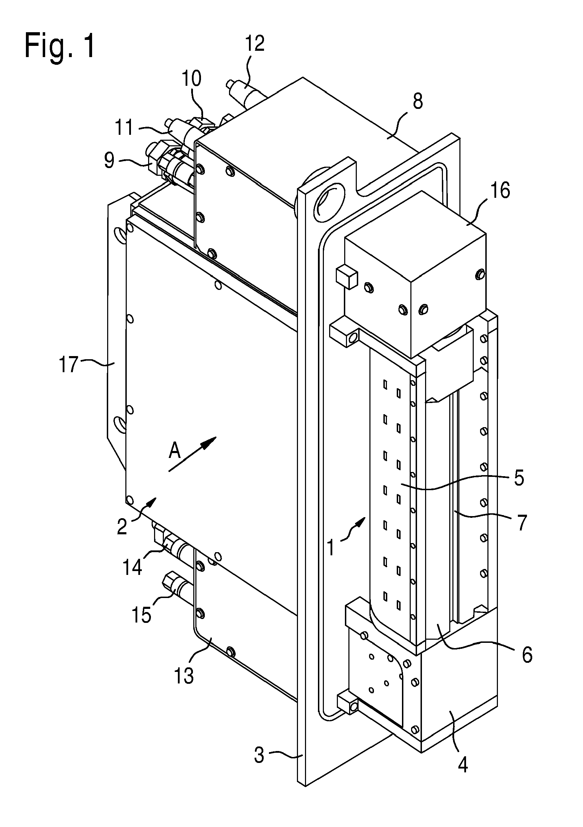

In der Fig. 1 ist ein Verdampfer 1 mit einem Drahtzuführungsgehäuse 2 dargestellt. Verdampfer 1 und Drahtzuführungsgehäuse 2 sind über eine Trägerplatte 3 miteinander verbunden. Der Verdampfer 1 enthält einen Schmelzraum 4, über dem sich ein Verteilergehäuse 5 befindet, das auch zur Kühlung dient. Das Verteilergehäuse 5 ist auf seiner Rückseite U-förmig gekrümmt und lässt an seiner vorne befindlichen Öffnung ein Verteilerrohr 6 erkennen, das einen linearen Verteilerschlitz 7 besitzt. Auf der Oberseite des Drahtzuführungsgehäuses 2 befindet sich ein Kasten 8, der Schnellkupplungen 9, 10 und Stecker 11, 12 aufweist. Desgleichen befindet sich auf der Unterseite des Drahtzuführungsgehäuses 2 ein Kasten 13 mit Schnellkupplungen 14, 15. Oberhalb des Verdampfers 1 ist ein weiterer Kasten 16 vorgesehen, in dem sich elektrische und elektronische Teile befinden. Mit 17 ist ein Flansch bezeichnet, der mit dem Drahtzuführungsgehäuse 2 verbunden ist und zum Anschluss an Vorrichtungen dient, die in der Fig. 1 nicht dargestellt sind.

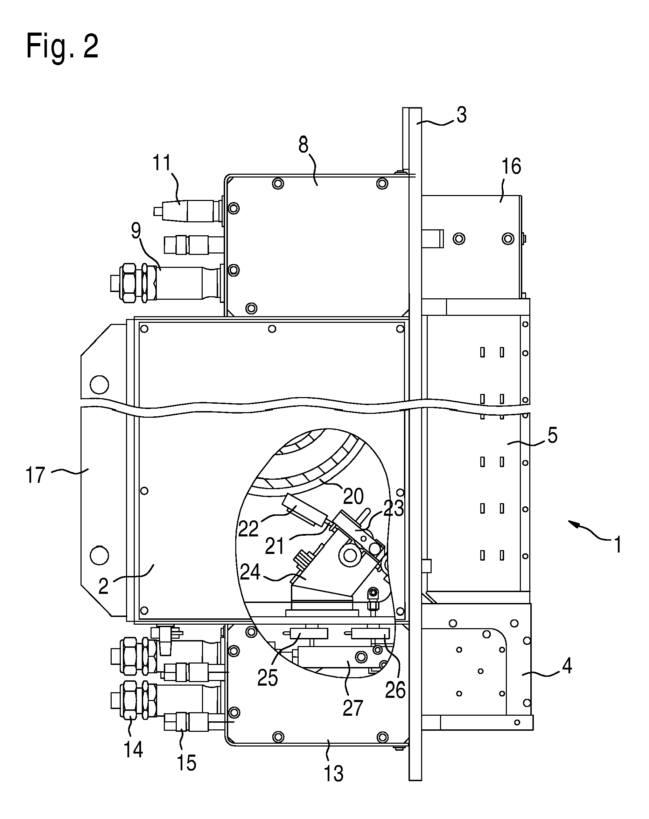

Die Fig. 2 zeigt eine Draufsicht A (vgl. Fig. 1) auf eine Seite des Verdampfers 1 mit dem Drahtzuführungsgehäuse 2. Man erkennt durch den Aufbruch des Drahtzuführungsgehäuses 2 eine Vorratsspule 20, auf der Draht aufgewickelt ist. Dieser Draht 21 gelangt von der Vorratsspule 20 über eine Drahtführung 22 in ein Drahtführungsmodul 24, das eine weitere Drahtführung 23 aufweist, und von dort in den Schmelzraum 4. Das Vakuum des Schmelzraums 4 wird somit durch die Drahtzuführung 2 nicht unterbrochen. Der Antrieb für die Bewegung des Drahts 21 ist nicht näher dargestellt.

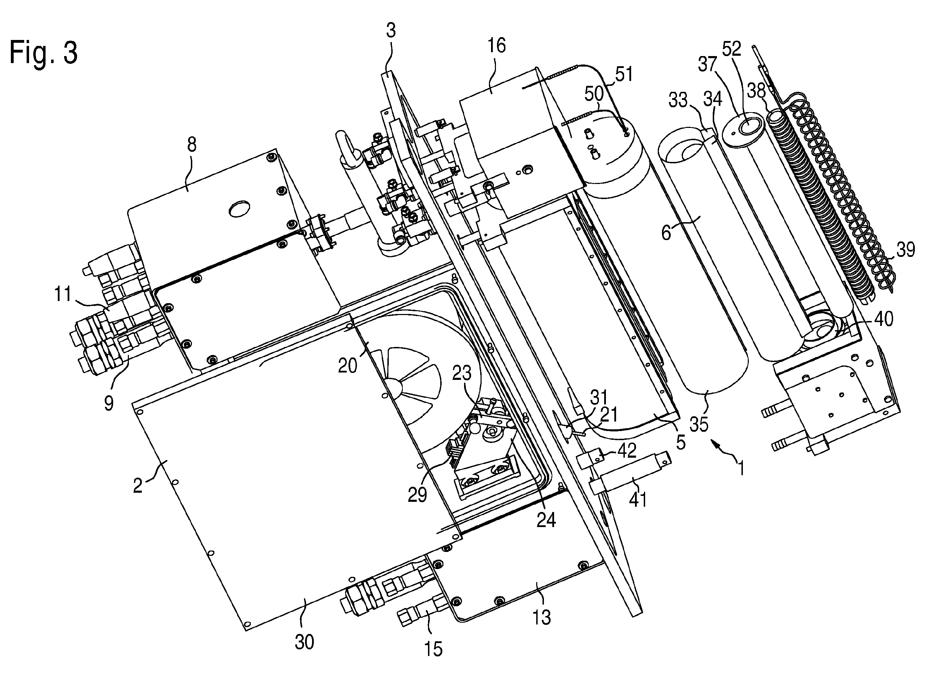

In der Fig. 3 ist der Verdampfer 1 noch einmal in einer Explosionsdarstellung gezeigt, bei welcher die einzelnen Bauelemente des Verdampfers 1 erkennbar sind. Eine Seitenwand 30 des Drahtzuführungsgehäuses 2 ist dabei etwas zur Seite geschoben, sodass man wieder die Vorratsspule 20 erkennt, von welcher der Draht 21 abgewickelt wird. Man erkennt, dass der Draht 21 über das Drahtzuführungsmodul 24 und durch ein Röhrchen 31 von dem Drahtzuführungsgehäuse 2 in den Verdampfer 1 geführt wird. Aus dem Verteiler 5, der gekühlt ist, sind herausgenommen: ein Stützrohr 35 für eine thermische Isolierung, ein Verdampferrohr 6 mit Dampfleitblechen 33, 34, ein Stütz- und Haltering 37 für ein Schutzrohr 52, ein Träger 38 für einen Spiralheizer und der Spiralheizer 39 selbst. Mit 40 ist ein Tiegel bezeichnet, der elektrisch isoliert und gekühlt ist.

Die Vorsprünge 41, 42 an dem Drahtzuführungsgehäuse 2 dienen als Halterung und Stromzuführung.

In das Stützrohr 35 führen zwei elektrische Leitungen 50, 51, die zur Aufheizung des Verdampferrohrs 6 dienen und an den Spiralheizer 39 angeschlossen werden.

Aus der Fig. 2, die den Verdampfer 1 mit dem Drahtzuführungsgehäuse 2 in zusammengebautem Zustand zeigt, ist ersichtlich, dass der Draht 21 dem Verdampfer 1 kontinuierlich zugeführt wird, ohne dass das Vakuum gebrochen wird. Mit 25 und 26 sind Spannringe zur Kühlmitteldurchführung bezeichnet, während es sich bei dem Bauteil 27 um eine Stromschiene handelt.

Die gesamte Vorrichtung gemäß Fig. 1 ist auf nur einer Trägerplatte 3 montiert, was ein schnelles Ein- und Ausbringen aus einem Reinraum ermöglicht, ohne dass störende Partikel erzeugt werden. Durch eine unabhängige Montage des Verdampfers 1 und des Drahtzuführungsgehäuses 2 auf der Trägerplatte 3 ist auch eine von den Einzelteilen unabhängige Skalierung für zukünftige Substratgrößen möglich.

Wie die Fig. 3 zeigt, befindet sich die elektrisch aufheizbare Spirale 39 - gestützt von dem Träger 38 - im Verdampferrohr.

Im zusammengebauten Zustand umgibt die Heizspirale 39 den Träger 38. Träger 38 und Heizspirale 39 werden in einem Schutzrohr 52 für die Heizspirale 39 untergebracht, das seinerseits von einem Stütz- und Haltering 37 für das Schutzrohr 52 umgeben ist. Alle diese Bauteile werden in das Verdampferrohr 6 eingebracht, das die Öffnung 7 mit den Dampfleitblechen 33, 34 aufweist. Das Verdampferrohr 6 nebst Inhalt wird dann in das Stützrohr 35 für thermische Isolierung gegeben, das seinerseits von dem Kühlgehäuse 5 umgeben ist. Mit 29 ist ein Anschlussfeld für den Antrieb eines Elektromotors der Drahtzuführung bezeichnet.

Der Tiegel 40 mit Isolierung und Kühlung befindet sich im zusammengebauten Zustand direkt auf den Haltern 41, 42 mit Stromzuführung und somit unterhalb des von der Kühlung 5 umgebenen Verdampferrohrs 6. In dieser Position kann auch auf direktem Weg der aus dem Verdampfungsmaterial bestehende Draht 21 von der Vorratsspule 20 dem Verdampfertiegel 40 zugeführt werden. Das Drahtzuführungsmodul 24 und die Vorratsspule 20 sind in einem vakuumdichten Gehäuse untergebracht, das vakuumtechnisch mit dem Verdampferrohr 6 und der Prozesskammer in Verbindung steht.

Das Schutzrohr 52 für den Heizdraht 39 dient dazu, ein Verspröden dieser Heizdrähte 39 durch aggressive Materialien, beispielsweise verdampftes Aluminium, zu verhindern.

Die einzelnen Komponenten der Vorrichtung 1, 2 sind konstruktiv so angeordnet und ausgelegt, dass sie unabhängig voneinander ausgewechselt werden können, ohne dass vorher andere Komponenten ausgebaut werden müssen. So ist z. B. der Verdampfertiegel 40 mit der ihn umgebenden Kühlung im Schmelzraum 4 so angeordnet, dass er leicht ausgetauscht werden kann.

## Patentansprüche

1. Verdampfervorrichtung mit automatischer Zuführung eines Drahts (21) in einen Tiegel (40), **gekennzeichnet durch**
a) eine Trägerplatte (3)
b) ein Drahtzuführungsgehäuse (2), das auf der einen Seite der Trägerplatte (3) lösbar angeflanscht ist
c) einen oberhalb des Tiegels (40) angeordneten linearen Verdampfer (1), der auf der anderen Seite der Trägerplatte (3) lösbar angeflanscht ist.

2. Verdampfervorrichtung nach Anspruch 1, **dadurch gekennzeichnet, dass** das Drahtzuführungsgehäuse (2) eine Aufwickelspule (20) für einen Draht (21) aufweist.

3. Verdampfervorrichtung nach Anspruch 1, **dadurch gekennzeichnet, dass** in der Trägerplatte (3) ein Durchbruch vorgesehen ist, durch den ein Draht (21) zum Tiegel (40) geführt ist.

4. Verdampfervorrichtung nach Anspruch 1, **dadurch gekennzeichnet, dass** der lineare Verdampfer (1) ein Stützrohr (35) enthält, in dem ein Verteilerrohr (6) mit einer Heizspirale (39) vorgesehen ist.

5. Verdampfervorrichtung nach Anspruch 4, **dadurch gekennzeichnet, dass** die Heizspirale (39) um einen Träger (38) geschlungen ist.

6. Verdampfervorrichtung nach den Ansprüchen 4 und 5, **dadurch gekennzeichnet, dass** Heizspirale (39) und Träger (38) in einem Schutzrohr (52) angeordnet sind.

7. Verdampfervorrichtung nach Anspruch 6, **dadurch gekennzeichnet, dass** das Schutzrohr (52) an wenigstens einem Ende mit einem Stützring (37) versehen ist.

## Geänderte Patentansprüche

### Geänderte Patentansprüche gemäss Regel 137(2) EPÜ.

**1.** Verdampfervorrichtung mit automatischer Zuführung eines Drahts (21) in einen Tiegel (40) und mit einer Trägerplatte (3), **gekennzeichnet durch**
a) ein Drahtzuführungsgehäuse (2), das auf der einen Seite der Trägerplatte (3) lösbar angeflanscht ist
b) einen oberhalb des Tiegels (40) angeordneten linearen Verdampfer (1), der auf der anderen Seite der Trägerplatte (3) lösbar angeflanscht ist.
